(19)

Europäisches
Patentamt
European
Patent Office
Office européen
des brevets

(11) EP 4 576 092 A1

(12) EUROPEAN PATENT APPLICATION

(43) Date of publication:
25.06.2025 Bulletin 2025/26

(21) Application number: 23220118.6

(22) Date of filing: 22.12.2023

(51) International Patent Classification (IPC):
G11C 11/22 (2006.01)    H10B 53/20 (2023.01)
H10B 53/30 (2023.01)

(52) Cooperative Patent Classification (CPC):
G11C 11/221; G11C 11/2255; G11C 11/2257;
G11C 11/2259; G11C 11/2273; G11C 11/2275;
H10B 53/20; H10B 53/30

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicant: Imec VZW
3001 Leuven (BE)

(72) Inventors:
• WALKE, Amey Mahadev
3001 Heverlee (BE)
• IZMAILOV, Roman
3000 Leuven (BE)

(74) Representative: Lind Edlund Kenamets
Intellectual Property AB
Kungsportsavenyn 25
411 36 Göteborg (SE)

(54) **FERROELECTRIC MEMORY DEVICE**

(57)    In an aspect there is provided a ferroelectric memory device comprising:

a memory array arranged in a back-end-of-line interconnect structure of the memory device, comprising:

a vertical stack of horizontally extending plate lines; and
a pillar structure extending vertically through the stack of plate lines and comprising a metal core and a storage layer stack comprising an oxide semiconductor layer circumferentially surrounding the metal core and a ferroelectric layer circumferentially surrounding the oxide semiconductor layer,

wherein a vertical stack of ferroelectric storage capacitors is defined along the pillar structure,

the memory device further comprising:

a bit line select transistor comprising a first current terminal coupled to a bit line of the memory array, a second current terminal coupled to the metal core of the pillar structure, and a gate terminal coupled to a bit select line;
a plate line select transistor coupled to a respective one of the plate lines; and
a sense circuit coupled to the metal core of the pillar structure.

Fig. 1

## Description

TECHNICAL FIELD

The present invention generally relates to a ferroelectric memory device.

BACKGROUND

Ferroelectric Random Access Memory (FeRAM) is a non-volatile memory technology using a ferroelectric capacitor to store information in the form of polarization states in a ferroelectric layer between the capacitor electrodes. The ferroelectric layer may be switched between two opposite polarization states by applying an electrical field of sufficient strength in a direction opposite to the current polarization state.

According to a conventional read operation, the polarization state of the ferroelectric capacitor may be sensed by applying by applying a voltage across the capacitor electrodes which results in charging of the bit line by an amount dependent on the polarization state of the ferroelectric capacitor. The read operation is hence destructive which means that following read, the sensed polarization state needs to be re-written to the ferroelectric capacitor.

An alternative read approach which has been investigated instead involves sensing the capacitance of the ferroelectric capacitor. This approach is based on that the capacitance of a ferroelectric layer changes with the polarization state of the ferroelectric layer. The change in capacitance demonstrated in a conventional metal-ferroelectric-metal (MFM) capacitor (e.g. comprising a ferroelectric layer of $Hf_{0.5}Zr_{0.5}O_2$) is however typically limited to about 10-20% (Luo et al, "Non-volatile, small-signal capacitance in ferroelectric capacitors", Appl. Phys. Lett. 117, 073501, 2020). Utilizing a metal-ferroelectric-semiconductor (MFS) or metal-ferroelectric-semiconductor-insulator (MFIS) stack, the polarization states of the ferroelectric layer may be pushed into depletion or accumulation, allowing a capacitance change of more than 100% (Tripathi et al., "Investigation of BiFeO3/HfO2 gate stack for ferroelectric field effect transistors in IOT applications", Journal of Materials Science: Materials in Electronics, 32: 22517-22526, 2021).

SUMMARY

While the above discussed techniques are promising, they are limited to proof-of-concept in a small-scale laboratory setting. Hence, it would be desirable to provide a ferroelectric memory device with a design allowing non-destructive read-out based on capacitive sensing, and which further is scalable to achieve high memory density. It is an object of the present invention to provide a ferroelectric memory device, suitable for FeRAM, addressing one or more of these aims.

Hence, according to an aspect of the present invention, there is provided a ferroelectric memory device comprising:
a memory array arranged in a back-end-of-line interconnect structure of the memory device, the memory array comprising:

> a vertical stack of horizontally extending plate lines; and
> a pillar structure extending vertically through the stack of plate lines and comprising a metal core and a storage layer stack comprising an oxide semiconductor layer circumferentially surrounding the metal core and a ferroelectric layer circumferentially surrounding the oxide semiconductor layer,
> wherein a vertical stack of ferroelectric storage capacitors is defined along the pillar structure, each ferroelectric storage capacitor comprising a first capacitor electrode formed by a plate line of the stack of plate lines, a second capacitor electrode formed by the metal core of the pillar structure, and a storage region formed by a portion of the storage layer stack sandwiched between the respective first capacitor electrode and the metal core;
> the memory device further comprising:

> > a bit line select transistor comprising a first current terminal coupled to a bit line of the memory array, a second current terminal coupled to the metal core of the pillar structure, and a gate terminal coupled to a bit select line;
> > a plate line select transistor coupled to a respective one of the plate lines; and
> > a sense circuit coupled to the metal core of the pillar structure.

Thus, the present aspect is based on the idea that a vertical stack of metal-ferroelectric-semiconductor-metal (MFSM) based ferroelectric (FE) storage capacitors may be implemented in an area efficient along a common vertical pillar structure comprising an inner metal core (M) forming a common capacitor electrode for the stack of ferroelectric storage capacitors, an oxide semiconductor layer (S) formed on a sidewall of the inner metal core to circumferentially surround the inner metal core, a ferroelectric layer (F) formed on the oxide semiconductor layer and circumferentially surrounding the same, and a stack of metal plate lines (M) defining individual capacitor electrodes of the respective ferroelectric storage capacitors of the stack.

As discussed in the background section, using in combination a ferroelectric layer and a semiconductor layer as a storage stack in a ferroelectric storage capacitor enables the ferroelectric layer polarization states to push the semiconductor layer into either depletion or accumulation, allowing a large capacitance change between the polarization states. This effect may be achieved also for an oxide semiconductor, as in the ferroelectric storage capacitors of the memory device of the present aspect. This enables the memory device to employ a capacitive-based sensing scheme for the sense circuit coupled to the metal core of the pillar structure. That is, the sense circuit may be configured to sense a polarization state of the ferroelectric layer by sensing a capacitance of any one of the ferroelectric storage capacitors of the vertical stack, e.g. selected by proper switching of the bit select transistor and the plate line select transistors. Techniques for capacitive sensing will be set out in detail below.

Additionally, providing the semiconductor layer as specifically an oxide semiconductor confers a number of advantages over a Si-based MFSM FE capacitor: Oxide semiconductor have larger bandgap than Si (> 3eV) and may not be inverted as easily due to lack of minority carriers. Meanwhile, the ferroelectric layer may programmed to push the oxide semiconductor layer into either accumulation (corresponding to a higher capacitance state) or depletion (corresponding to a lower capacitance state).

Moreover, conventional Si-based MFS devices may comprise a SiOx interfacial layer which may lead to trapping of electrons, which in turn may reduce endurance performance. A conventional Si-based MFS device is typically limited to $10^4$ to $10^6$ cycles. However, an interfacial layer may be omitted in the oxide semiconductor-based MFSM-capacitor of the present aspect. This enables lower trapping and hence higher endurance (e.g. > $10^8$ cycles as an estimate).

Additionally, the depolarization field in an oxide semiconductor-based MFSM capacitors can be lower than in Si-based MFSM, again due to absence of the interfacial oxide layer. This enables an enhanced retention.

Since the inner metal core acts as a common capacitor electrode for the stack of FE capacitors, both the bit line select transistor and the sense circuit may be shared by all ferroelectric storage capacitors of the stack. Meanwhile, the provision of a respective plate line select transistor for each ferroelectric storage capacitor of the stack facilitates individual addressing of any FE capacitor of the stack.

In some embodiments, the bit line select transistor is arranged on top of the pillar structure and comprises a channel layer of an oxide semiconductor material. The bit line select transistor may hence be stacked on top of the vertical stack of ferroelectric storage capacitors, further contributing to an area efficient implementation. The stacking is enabled by the oxide semiconductor material of the channel layer, which is compatible with back of end line processing.

The oxide semiconductor layer of the pillar structure and/or the channel layer may be formed of a same or a different oxide semiconductor material. Using a same material may enable a more rational fabrication. Employing an oxide semiconductor material with a high channel mobility for the channel layer of the bit line select transistor may further enable efficient driving of the bit lines.

In some embodiments, the metal core of the pillar structure is coupled to a reference voltage node via a reference capacitor arranged below the vertical stack of ferroelectric storage capacitors, and wherein the sense circuit is coupled to a sense node between the metal core and the reference capacitor. The reference capacitor may thus together with the metal core be configured to define a capacitive divider. By being coupled to the sense node between the metal core and the reference capacitor (i.e. the sense node of the capacitive divider), the sense circuit may thus be configured to sense the capacitance at the sense node and thus sense the polarization state implied by the capacitance. The reference capacitor allows the effective capacitance at the sense node to be tuned, to facilitate the capacitive sensing.

By virtue of the ferroelectric layer, each ferroelectric storage capacitor of the stack of ferroelectric storage capacitors is switchable between a first polarization state resulting in a first capacitance of the ferroelectric storage capacitor, and a second polarization state resulting in a second capacitance of the ferroelectric storage capacitor, the second capacitance being smaller than the first capacitance.

In some embodiments, a ratio of the capacitance at the sense node and the second capacitance (second capacitance ratio CR2) exceeds a ratio of the capacitance at the sense node and the first capacitance (first capacitance ratio CR1) by a factor of 1.3 or more. A greater ratio implies a greater capacitance difference between the two polarization states of the ferroelectric storage capacitors. This in turn means that a lower read voltage is needed to readily distinguish between the first and second polarization states. A second capacitance ratio-to-first capacitance ratio of 1.3 (i.e. CR2/CR1 ≥ 1.3) or more is enabled by the MFSM-structure of the ferroelectric storage capacitors. Indeed, the oxide semiconductor layer enables even higher ratios are possible, such as CR2/CR1 ≥ 2 or even CR2/CR1 ≥ 3.

Depending on the conductivity type (n or p) of the oxide semiconductor layer, the first polarization state (higher capacitance) may correspond to an erased state of a ferroelectric capacitor and the second polarization state may correspond to a programmed state of a ferroelectric capacitor (for n-type), or vice versa (for p-type).

In some embodiments, the memory device further comprises a memory controller configured to perform a read operation for determining a polarization state of a selected ferroelectric storage capacitor among the stack of ferroelectric storage capacitors by:

disabling each bit line select transistor;
enabling the plate line select transistor coupled to the plate line associated with the selected ferroelectric storage capacitor;
applying, via the enabled plate line select transistor, a read voltage to the plate line associated with the selected ferroelectric storage capacitor, wherein the read voltage is distributed across the selected ferroelectric storage capacitor and the reference capacitor; and

determining the polarization state of the selected ferroelectric storage capacitor by sensing, using the sense circuit, the voltage at the sense node responsive to the read voltage.

According to the read operation, the memory controller may thus select a ferroelectric storage capacitor among the stack of storage capacitors whose polarization state is to be read, and determine the polarization state based on the voltage at the sense node resulting from the read voltage.

The read voltage may be a magnitude to ensure that read operation does not result in state switching of the FE storage capacitor. In other words, the read voltage is such that the part of the read voltage distributed across the selected ferroelectric storage capacitor is smaller than required for switching the polarization state of the selected ferroelectric storage capacitor.

In some embodiments, the sense circuit comprises a differential amplifier configured to compare the voltage at the sense node to a reference sense voltage. The polarization state of the selected ferroelectric storage capacitor may hence be determined by comparing the sense node voltage produced by the read voltage to a reference sense voltage. The differential amplifier may thus detect and amplify a difference between the sense node voltage and the reference sense voltage, wherein the difference is indicative of the polarization state.

In some embodiments, the sense circuit may instead comprise a sense transistor having a gate coupled to the sense node, a first current terminal coupled to the reference voltage node and a second current terminal coupled to an amplifier of the memory device. The sense node voltage may hence be used to bias the gate of the sense transistor, thereby influencing a drain-source current and drain voltage of the sense transistor, which in turn may be amplified or sensed by the sense amplifier. The amplifier may be a sense amplifier configured to sense the voltage at the sense node by sensing a current through the sense transistor responsive to the read voltage.

In some embodiments, the effective capacitance at the sense node is such that, responsive to the read voltage, the sense transistor is enabled when the selected ferroelectric storage capacitor is in the first polarization state, and disabled when the selected ferroelectric storage capacitor is in the second polarization state. Thus the sense node voltage may be used to either switch off or switch on the sense transistor, thus creating large difference in sense current between the polarization states.

The memory device of the first aspect may be extended to comprise a plurality of vertical stacks of memory cells. Hence, in some embodiments, the stack of plate lines extend in a row direction of the memory array and the memory array further comprises a set of bit lines, wherein the bit lines extend over and across the stack of plate lines in a column direction of the memory array to define a row of cross points between the set of bit lines and the stack of plate lines, the memory array comprising:

a pillar structure at each cross point, each pillar structure extending vertically through the stack of plate lines and comprising a metal core and a storage layer stack comprising a ferroelectric layer and an oxide semiconductor layer circumferentially surrounding the metal core,

wherein a vertical stack of ferroelectric storage capacitors is defined along the respective pillar structure at each cross point, each ferroelectric storage capacitor of each stack of ferroelectric storage capacitors comprising a first capacitor electrode formed by a plate line of the stack of plate lines, a second capacitor electrode formed by the metal core of the respective pillar structure, and a storage region formed by a portion of the storage layer stack of the respective pillar structure sandwiched between the respective first capacitor electrode and the respective metal core;

wherein the memory device comprises a respective bit line select transistor associated with each respective cross point, each comprising a first current terminal coupled to the bit line at the respective cross point, a second current terminal coupled to the metal core of the pillar structure at the respective cross point, and a gate terminal coupled to a bit select line; wherein the sense circuit is connected to the metal core of each pillar structure.

A number of pillar structures corresponding to the number of bit lines may hence be arranged to extend through the stack of plate lines and accordingly define a row of vertical stack of FE storage capacitors. The stack of plate lines may hence be shared by the row of vertical stacks of ferroelectric storage capacitors. The details and advantages discussed above with reference to a single vertical stack of ferroelectric storage capacitors applies correspondingly to each of the vertical stacks of the row.

In some embodiments, each bit line select transistor is arranged on top of the pillar structure at the associated cross point and comprises a channel layer of an oxide semiconductor material. Analogous to the above discussion, bit line select transistors compatible with back end of line integration may hence be provided for each stack of ferroelectric storage capacitors with substantially no area penalty.

In some embodiments, the gate terminal of each bit line select transistor is coupled to a respective bit select line. Hence, any stack of ferroelectric storage capacitors may be individually addressed, e.g. during reading or writing, by selective biasing of its associated bit select line.

In some embodiments, the gate terminals of the bit line select transistors along the row are instead coupled to a same bit select line. Since the metal pillars forming the common second capacitor electrode of the respective vertical stacks of ferroelectric storage capacitors are coupled to a respective sense circuit, selective reading of any ferroelectric storage capacitor along the row is possible despite a shared bit select line. A shared bit select line may thus facilitate routing and biasing schemes during read. Furthermore, the vertical stacks may be more closely spaced since space for insulating regions between the gate terminals of the bit line select transistors is not needed. In addition to offering higher density, fabrication cost and complexity may be reduced since fewer processing masks are needed. However, additional considerations may be needed for selective writing, as will be further discussed below.

In embodiments wherein the gate terminal of each bit line select transistor is coupled to a respective bit select line, the memory device may further comprise write circuitry implementing a first write scheme, wherein the write circuitry may be configured to:

selectively enable one of the plate line select transistors, the enabled plate line select transistor being coupled to a plate line (hereinafter "selected plate line") associated with a first set of ferroelectric storage capacitors to be erased and a second set of ferroelectric storage capacitors to be programmed, and while the selected plate line select transistor is enabled:

perform an erase step comprising: selectively enabling the bit line select transistors coupled to the first set of ferroelectric storage capacitor, and simultaneously applying (i.e. applying while the bit line select transistors are enabled) an erase voltage to the selected plate line and a reference voltage to the bit lines coupled to the enabled bit line select transistors; and

perform a program step comprising: selectively enabling the bit line select transistors coupled to the second set of ferroelectric storage capacitors, and simultaneously applying (i.e. applying while the bit line select transistors are enabled) a program voltage to the bit lines coupled to the enabled bit line select transistors and the reference voltage to the selected plate line.

Thereby, an erase step and a program step may be sequentially applied to ferroelectric storage capacitors along a selected plate line. The erase step may be performed prior to the program step or after.

The first and second sets of ferroelectric storage capacitors may each comprise one or more ferroelectric storage capacitors.

The erase voltage and the program voltage may each be positive voltages (i.e. with respect to the reference voltage). The reference voltage may typically be a ground reference voltage, e.g. approximately 0 V. This is a convenient choice since negative bias generators will then not be needed for generating the reference voltage. In any case it is to be understood that the bias across each storage capacitor of the first set of ferroelectric storage capacitors resulting from the reference voltage and the erase voltage should be of a polarity and magnitude sufficient to the ferroelectric storage capacitors to the erase state (corresponding to the first capacitance value if the oxide semiconductor layer is n-type and the second capacitance value if the oxide semiconductor layer is p-type). This applies correspondingly to the reference voltage and the program voltage.

Since the erase and program steps are applied via the individually addressable bit lines, the erase and program voltages may be applied selectively. The first write scheme is hence associated with a low risk of disturbing ferroelectric storage capacitors along the selected plate line not selected for erase or write.

However, in non-ideal circumstances there may be leakage through non-enabled select transistors and/or capacitive coupling via unintentional potential dividers, such that the erase and program voltages applied to the selected plate and bit lines still may disturb non-selected ferroelectric storage capacitors.

Therefore, to further reduce the risk for disturb during erase, the erase step may further comprise: simultaneously to applying the erase voltage to the selected plate line and the reference voltage to the bit lines coupled to the enabled bit line select transistors, applying a fractional program voltage to the bit lines coupled to the second set of ferroelectric storage capacitors. In particular, the fractional program voltage may be applied to all non-selected bit lines (i.e. the bit lines coupled to non-enabled bit line select transistors).

Correspondingly, to further the risk for disturb during programming, the program step may further comprise: simultaneously to applying the program voltage to the bit lines coupled to the enabled bit line select transistors and the reference voltage to the selected plate line, applying a fractional program voltage to the bit lines coupled to the first set of ferroelectric storage capacitors. In particular, the fractional program voltage may be applied to all non-selected bit lines (i.e. the bit lines coupled to non-enabled bit line select transistors).

This enables the voltage across non-selected ferroelectric storage capacitors to be kept small (ideally close to 0 V) during erase and programming, respectively.

The fractional program voltage may be approximately half the program voltage. More generally, the fractional program voltage may be any (positive) voltage corresponding to a fraction of the program voltage, such that a bias across non-selected ferroelectric storage capacitors may be limited during erase and programming.

For corresponding reasons, to further reduce the risk of disturbing ferroelectric storage capacitors along the non-selected plate lines, the write circuitry may be further configured to, during both the erase step and the program step, further apply a fractional erase voltage to non-selected plate lines. The fractional erase voltage may be approximately half the erase voltage. More generally, the fractional erase voltage may be any (positive) voltage corresponding to a fraction of the erase voltage, such that a bias across non-selected ferroelectric storage capacitors along non-selected plate lines may be limited during erase and programming.

In embodiments wherein the gate terminals of the bit line select transistors are coupled to a same bit select line, the memory device may further comprise write circuitry implementing a second write scheme, wherein the write circuitry may be configured to:

> selectively enable one of the plate line select transistors and each bit line select transistor, the enabled plate line select transistor being coupled to a plate line (hereinafter "selected plate line") associated with a first set of ferroelectric storage capacitors to be erased and a second set of ferroelectric storage capacitors to be programmed,
> and while the selected plate line select transistor and each bit line select transistor are enabled:
>
>> perform an erase step comprising: simultaneously applying an erase voltage to the selected plate line and a reference voltage to each bit line; and
>> perform a program step comprising: simultaneously applying a program voltage to the bit lines coupled to the second set of ferroelectric storage capacitors and a fractional program voltage to the bit lines coupled to first set of ferroelectric storage capacitors, and the reference voltage to the selected plate line.

Thereby, an erase step and a program step may be sequentially applied to ferroelectric storage capacitors along a selected plate line. The erase step may typically be performed prior to the program step. Hence, all ferroelectric storage capacitors along the selected plate line may first be erased, and then the program voltage may be applied selectively to the second set of FE storage capacitors which are to be programmed, such that the first set of FE storage capacitors remain in the erased state.

Like for the first write scheme, the erase voltage and the program voltage may each be positive voltages (i.e. with respect to the reference voltage). The reference voltage may typically be a ground reference voltage, e.g. approximately 0 V. This is a convenient choice since negative bias generators will then not be needed for generating the reference voltage. In any case it is to be understood that the bias across each storage capacitor of the first and second set of ferroelectric storage capacitors resulting from the reference voltage and the erase voltage should be of a polarity and magnitude sufficient to the ferroelectric storage capacitors to the erase state (corresponding to the first capacitance value if the oxide semiconductor layer is n-type and the second capacitance value if the oxide semiconductor layer is p-type). Correspondingly, the bias across each storage capacitor of the second set of ferroelectric storage capacitors resulting from the reference voltage and the program voltage should be of a polarity and magnitude sufficient to set the ferroelectric storage capacitors of the second set to the program state (corresponding to the second capacitance value if the oxide semiconductor layer is n-type and the first capacitance value if the oxide semiconductor layer is p-type). Meanwhile, the bias across each storage capacitor of the first set of ferroelectric storage capacitors resulting from the reference voltage and the fractional program voltage should be of a polarity and magnitude such that the ferroelectric storage capacitors of the first set remain in the erased state.

Since the erase and program steps are applied via the commonly addressable bit lines, the second write scheme is associated with an increased risk of disturbing ferroelectric storage capacitors along the non-selected plate lines.

Therefore, the write circuitry may be further configured to, during the program step, further apply a fractional erase voltage to non-selected plate lines. The fractional erase voltage may be approximately two thirds (~2/3) of the erase voltage. More generally, the fractional erase voltage may be any (positive) voltage corresponding to a fraction of the erase voltage, such that a bias across non-selected ferroelectric storage capacitors along non-selected plate lines may be limited during erase and programming. The write circuitry may be further configured to, during the erase step, further apply the reference voltage to non-selected plate lines.

In some embodiments, the plate line select transistor or transistors and the sense circuit is comprised in a peripheral complementary metal oxide semiconductor, CMOS, circuit of the memory device.

The memory device of the first aspect may be further extended to comprise a number (e.g. two or more) of vertical stacks of plate lines, wherein a row of vertical stacks of ferroelectric storage capacitors is formed along each stack of plate lines. Accordingly, in some embodiments, the memory array comprises:

> a set of vertical stacks of plate lines extending in parallel in a row direction of the memory array and spaced apart in a column direction of the memory array, wherein the set of bit lines extend over and across each stack of plate lines to define a define a number of rows and columns of cross points between the set of bit lines and the stacks of plate lines, a pillar structure at each cross point, each pillar structure extending vertically through the stack of plate lines at the cross point, and comprising a metal core and a storage layer stack comprising a ferroelectric layer and an oxide semiconductor layer circumferentially surrounding the metal core,

wherein a vertical stack of ferroelectric storage capacitors is defined along the respective pillar structure at each cross point, each ferroelectric storage capacitor of each stack of ferroelectric storage capacitors comprising a first capacitor electrode formed by a plate line of the stack of plate lines located at the cross point, a second capacitor electrode formed by the metal core of the respective pillar structure, and a storage region formed by a portion of the storage layer stack of the respective pillar structure sandwiched between the respective first capacitor electrode and the respective metal core;

wherein the memory device comprises a respective bit line select transistor associated with each respective cross point, each comprising a first current terminal coupled to the bit line at the respective cross point, a second current terminal coupled to the metal core of the pillar structure at the respective cross point, and a gate terminal coupled to a bit select line;

wherein the sense circuit of the CMOS periphery is connected to the metal core of each pillar structure.

The details and advantages discussed above with reference to a single stack of plate lines and a single row of vertical stacks of FE storage capacitors applies correspondingly to each of the stacks of plate lines and each of the rows of vertical stacks. The discussion will hence not be repeated here but reference is made to the above.

In some embodiments, the bit line select transistors arranged along a same column of cross-points are coupled to a common bit line.

In some embodiments, the gate terminals of bit line select transistors arranged along a same row are coupled to a same bit select line or to a respective bit select line.

In some embodiments, the gate terminals of the bit line select transistors are formed in a gate metal layer overlying each of sets of stacks of plate lines.

In some embodiments, each stack of plate lines defines a staircase structure located in a peripheral region of the memory array, and wherein each plate line is coupled to the respective plate line select transistor by a horizontal plate interconnect line arranged in an interconnect level over the staircase structure, a first and second vertical plate interconnect extending from the horizontal plate interconnect and landing respectively on the plate line at the staircase structure, and a current terminal of the respective plate line select transistor.

BRIEF DESCRIPTION OF THE DRAWINGS

This and other aspects of the present invention will now be described in more detail, with reference to the appended drawings showing embodiments of the present invention.

Fig. 1 schematically shows a first cross sectional view of a memory device according to an embodiment.

Fig. 2 schematically shows a second cross sectional view of the memory device of Fig. 1.

Fig. 3 schematically shows a third cross sectional view of the memory device of Fig. 1.

Fig. 4 schematically shows a top-down view of the memory device of Fig. 1.

Fig. 5 shows a circuit diagram for the part of the memory device shown in the first cross sectional view of Fig. 1.

Fig. 6a-c show different implementations of a sense circuit.

Fig. 7 shows a first write scheme suitable for the memory device of Fig. 1.

Fig. 8 schematically shows a cross sectional view of a memory device according to a further embodiment.

Fig. 9 schematically shows a top-down view of the memory device of Fig. 8.

Fig. 10 shows a second write scheme suitable for the memory device of Fig. 9.

DETAILED DESCRIPTION

Embodiments of a memory device based on a vertical stack of ferroelectric storage capacitors will now be described with reference to the drawings. The drawings are only schematic and the relative dimensions of some structures and layers may be exaggerated and not drawn on scale. Rather the dimensions may be adapted for illustrational clarity and to facilitate understanding of the following description. When present in the figures, the indicated axes X, Y and Z consistently refer to a first horizontal or lateral direction, a second horizontal or lateral direction, and a vertical direction, respectively. As used herein, the terms "horizontal" and "lateral" refer to directions parallel to a supporting substrate of a memory device. The term "vertical" refers to a direction parallel to a normal direction of the substrate, i.e. transverse to the substrate. The X and Y directions may respectively be referred to as a row direction and a column direction of a memory array of a memory device.

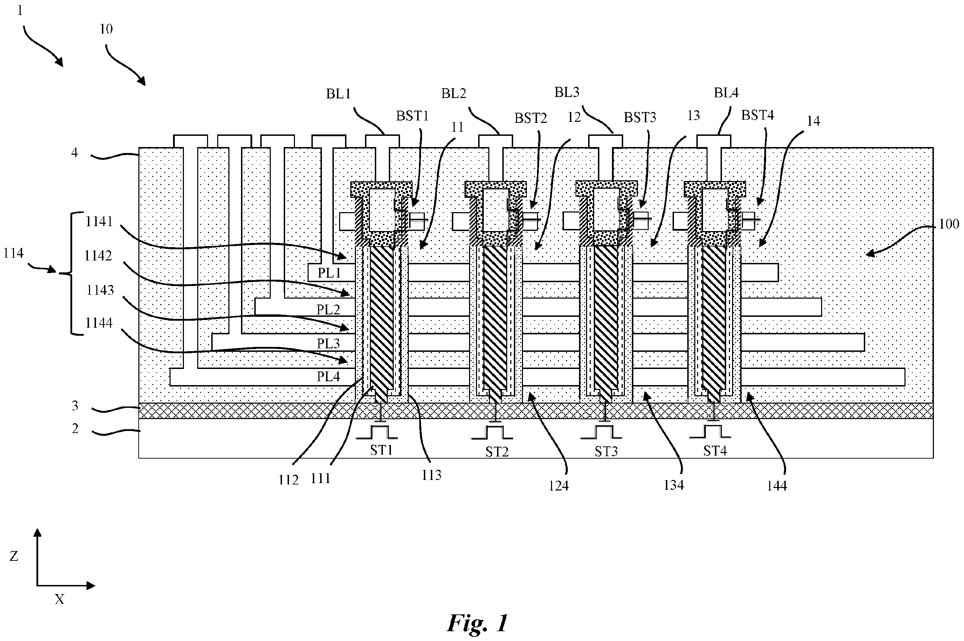

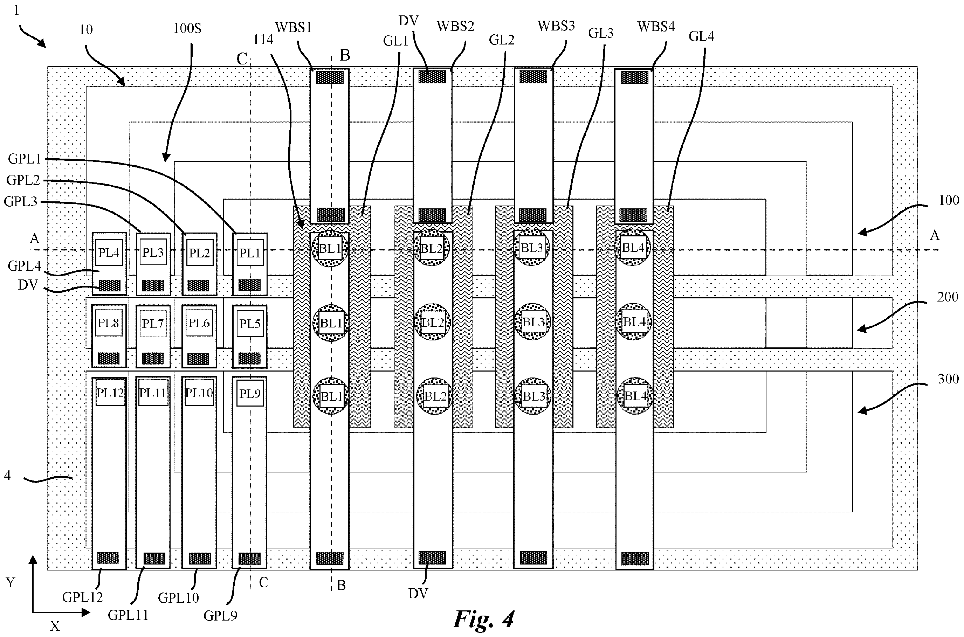

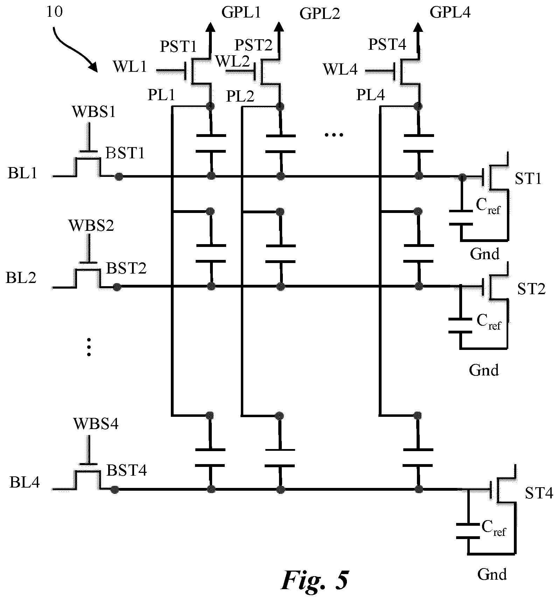

Fig. 1-3 schematically show first, second and third cross sectional views of a ferroelectric memory device 1 (hereinafter interchangeably "memory device"), taken along the lines A-A, B-B and C-C, respectively, indicated in the top-down view of Fig. 4. Fig. 5 further shows a circuit diagram for the part of the memory device 1 shown in the first cross sectional view of Fig. 1.

The memory device 1 comprises a substrate 2 and a memory array 10 arranged in a back-end-of-line (BEOL) interconnect structure of the memory device 1, arranged on the substrate 2. The memory array 10 comprises a vertical stack of plate lines 100 extending horizontally in the row direction X of the memory array 10.

The memory array 10 further comprises a pillar structure 11. As used herein, and consistent with Fig. 1, the term "pillar structure" refers to a pillar-shaped structure (typically cylindrical) extending in the vertical direction Z with respect to the substrate 2.

The pillar structure 11 extends vertically through the stack of plate lines 100. The pillar structure 11 comprises a vertically extending metal core 111 (e.g. typically cylindrical). The metal core 111 is circumferentially surrounded by a storage layer stack. The storage layer stack comprises an oxide semiconductor layer 112 arranged on a circumferential sidewall of the metal core 111 and circumferentially surrounding the metal core 111. The storage layer stack further comprises a ferroelectric layer 113 arranged on and circumferentially surrounding the oxide semiconductor layer 112. The storage layer stack may accordingly define an annular and hollow cylindrical layer stack about the metal core 111.

By the vertical extension of the pillar structure 11 through the stack of plate lines 100, a vertical stack of ferroelectric storage capacitors 114 (hereinafter interchangeably "storage capacitor stack") is defined along the pillar structure 11. The storage capacitor stack 114 comprises ferroelectric storage capacitors (hereinafter interchangeably "storage capacitors") in a number corresponding to the number of plate lines of the stack of plate lines 100. In the illustrated example, the stack of plate lines 100 comprises four plate lines PL1-PL4, and hence the storage capacitor stack 114 comprises four storage capacitors 1141, 1142, 1143, 1144. Each storage capacitor 1141, 1142, 1143, 1144 comprises as shown a first capacitor electrode formed by a respective plate line of the stack of plate lines 100, a second capacitor electrode formed by the metal core 111 of the pillar structure 11, and a storage region formed by the portion of the storage layer stack (i.e. the oxide semiconductor layer 112 and the ferroelectric layer 113) sandwiched laterally between the respective first capacitor electrode and the metal core.

The metal core 111 may be formed of any suitable CMOS compatible metals, e.g. with sufficiently low resistance and fill properties. Non-limiting examples of metals for the metal core 111 include W, TiN, Ti, Ru, Cu, Ta, TaN, or Al, or combinations thereof.

The oxide semiconductor layer 112 may be formed of one or more suitable oxide semiconductors, e.g. with a sufficiently large bandgap. Single-, dual- or multi-layered compositions of the oxide semiconductor layer 112 are possible. Non-limiting examples of suitable oxide semiconductor materials include indium gallium zinc oxide (IGZO), ZnO, WO, InWO, InSnO, GaZnO, MgZnO, MgAlZnO and MoO.

The ferroelectric layer 113 may be formed of any suitable ferroelectric materials, e.g. with sufficiently large electric coercivity. Single-, dual- or multi-layered compositions of the ferroelectric layer 113 are possible. Further, one or more ferroelectric material layers may be combined with one or more dielectric layers to form a composite ferroelectric layer 113. Non-limiting examples of a ferroelectric material include HZO or $HfO_2$, either doped or un-doped. Possible dopants for HZO include La, Al, Sc, Gd, Y. Possible dopants for $HfO_2$ include the aforementioned dopants and additionally Si. Further non-limiting examples of suitable ferroelectric materials include HfAlO, PZT, BaTiOs, PbTiOs, $PbZrO_3$, and $BiFeO_3$.

The plate lines 100 may be formed of any suitable metal conventional used for forming metal line interconnects in the BEOL, e.g. W, Al, Cu.

Each storage capacitor 1141, 1142, 1143, 1144 is is switchable between a first polarization state resulting in a first capacitance $C_{high}$, and a second polarization state resulting in a second capacitance $C_{low} < C_{high}$. The ferroelectric layer 113 allows each storage capacitor to retain a polarization state written to the storage capacitor and may thus be used as a non-volatile storage element.

The memory device 1 further comprises a bit line select transistor BST1 arranged on top of the pillar structure 11. The bit line select transistor BST1 comprises a first current terminal (e.g. a drain) coupled to a bit line BL1 of the memory array 1, a second current terminal (e.g. a source) coupled to the metal core 111 of the pillar structure 11, and a gate terminal coupled to a bit select line WBS1. The second current terminal of the bit line select transistor BST1 may for example be arranged directly on, i.e. in physical contact with the metal core 111, thereby avoiding the need for additional vertical interconnects between the bit line select transistor BST1 and the metal core 111.

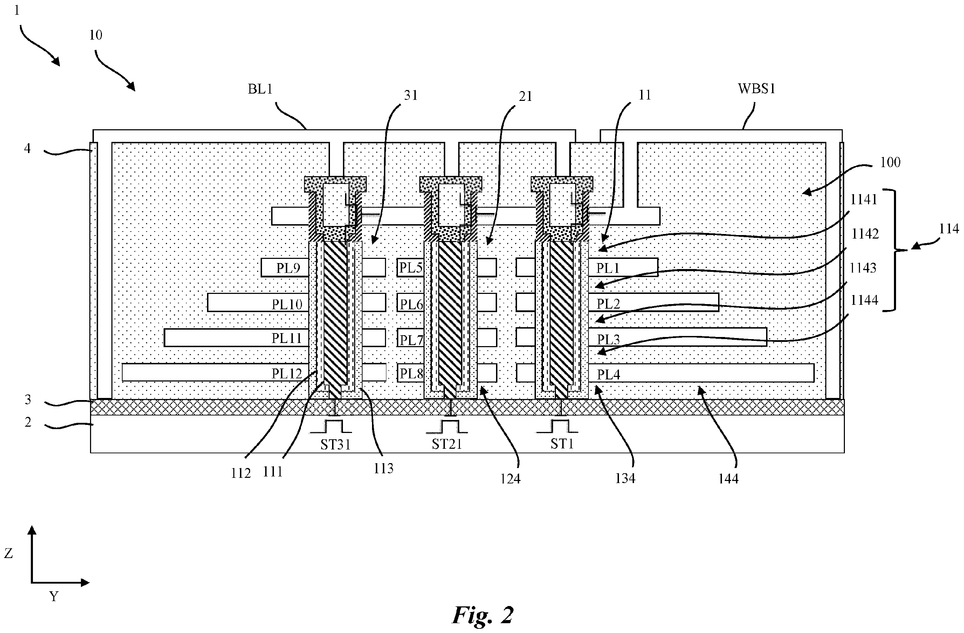

The gate terminal of the bit line select transistor BST1 may as shown in Fig. 4 be formed by a gate metal layer GL1 overlying the stack of plate lines 100 and surrounding the channel layer of the bit line select transistor BST1. The gate metal layer GL1 may be coupled to the bit select line WBS1 by a vertical connect (e.g. a metal via). The connection between the gate terminal / gate metal layer GL1 and the bit select line WBS1 is visible in Fig. 2 and Fig. 4, as well as in the circuit diagram of Fig. 5. The bit select line WBS1 may in turn be coupled to a bit line driver comprised in peripheral CMOS circuitry (interchangeably "CMOS periphery") indicated by reference sign 3 in Fig. 1-3). For BEOL-compatibility, the bit line select transistor BST1 may comprise a channel layer of an oxide semiconductor material, for instance a high-mobility oxide semiconductor material, such as any of the oxide semiconductor materials mentioned in connection with the oxide semiconductor layer 112. The bit line select transistor BST1 is configured to enable selective access to the associated storage capacitor stack 114.

In Fig. 4, each rectangular box with a dotted fill pattern (one example indicated by reference sign DV) indicates a location (in the horizontal plane XY) of a via extending vertically between and interconnecting the line overlapped by the respective rectangular box (e.g. a bit line BL1-BL4, a bit select line WBS1-WBS4, a global plate line GPL1-GPL4) and a corresponding interconnect in the CMOS periphery 3 underneath the array 10).

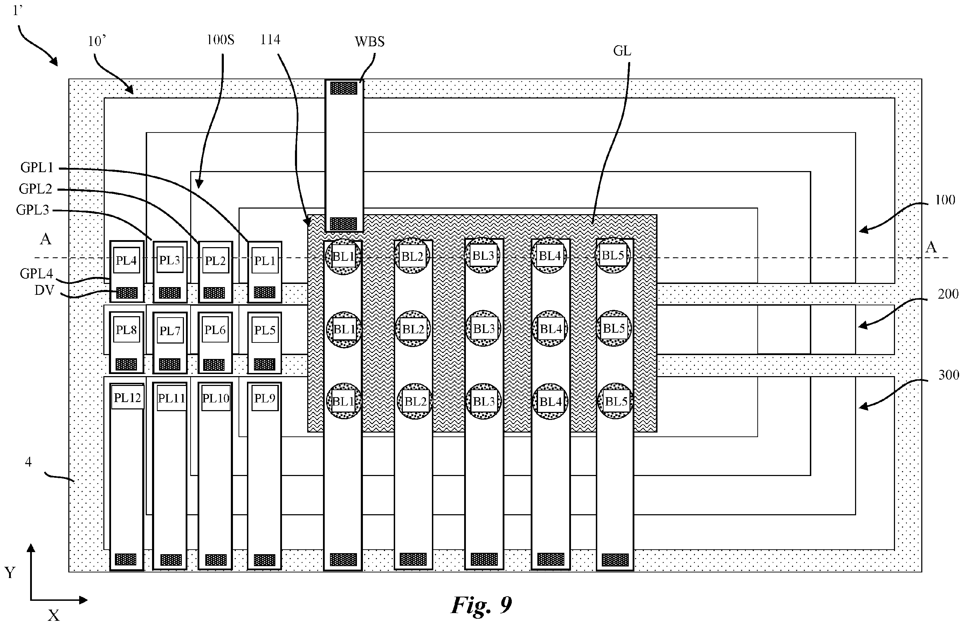

Correspondingly, the rectangular boxes labelled PL1-PL12 and BL1-BL4 each indicate a location of a respective via extending vertically between and interconnecting the line overlapped by the respective box (e.g. a bit line BL1-BL4, a global plate line GPL1-GPL4) and a corresponding interconnect (e.g. a drain of a bit line select transistor BST1-BST4 or a plate line PL1-PL4). An corresponding convention applies to the top-down view of Fig. 9 discussed later.

The memory array 10 comprising the stack of plate lines 100, the stack of storage capacitors and the bit line select transistor BST1 bit may further as shown be embedded in an insulating layer 4, e.g. comprising an oxide such as silicon oxide.

The memory device 1 further comprises plate line select transistors PST1-PST4, each coupled to a respective one of the plate lines PL1-PL4. The plate line select transistors are not individual shown in the structural views of the memory device in Fig. 1-3, but may be comprised in the CMOS periphery 3. The plate line select transistors are however shown in the circuit diagram of Fig. 4. Each plate line select transistor PST1-PST4 comprises a first current terminal (e.g. a drain) coupled to a respective plate line driver (e.g. comprised in the CMOS periphery 3) via a respective global plate line GPL1-GPL4, a second current terminal (e.g. a source) coupled to a respective plate line PL1-PL4, and a gate coupled to a respective plate select line WL1-WL4. The plate line select transistors PST1-PST4 are configured to configured to enable selective access to the associated plate line PL1-PL4 of the stack of plate lines 100.

The memory device 1 further comprises a sense circuit coupled to the metal core 111 of the pillar structure 11. As schematically indicated in Fig. 1-4, the sense circuit may comprise a sense transistor ST1. The sense transistor ST1 may as shown be comprised in the CMOS periphery 3 and be arranged underneath the pillar structure 11. The sense transistor ST 1 may as shown be located at least partly within the footprint of the storage capacitor stack 114. For instance, the metal core 111 may be formed directly on top of a gate contact coupled to the gate of the sense transistor ST1. A more detailed discussion of sense circuit implementations will be discussed below.

With reference to Fig. 1, the stack of plate lines 100 may define a staircase structure 100S located in a peripheral region of the memory array 10. Each plate line PL1-PL4 may thus as shown be coupled to its associated plate line select transistor PST1-PST4 by a horizontal plate interconnect line arranged in an interconnect level over the staircase structure, a first and second vertical plate interconnect extending from the horizontal plate interconnect and landing respectively on the plate line at the staircase structure, and a current terminal of the respective plate line select transistor. The first vertical plate interconnect for each plate line PL1-PL4 is visible in Fig. 1. The first and second vertical plate line interconnects associated with the plate line PL1 are visible in Fig.

3 The second vertical plate line interconnects associated with the further plate lines PL2-PL4 are located outside the cross sections in Fig. 1-3.

The bit line BL1 coupled to the bit line select transistor BST1 may as shown be arranged to extend over and across the stack of plate lines 100 in the column direction Y, to define a cross point between the stack of plate lines 100 and the bit line BL1. The pillar structure 11, and thus the storage capacitor stack 114, may further be arranged at the cross point. As shown in e.g. Fig. 1 and 4, the memory device 1 may comprise a set of bit lines BL1, BL2, BL3, BL4 extending in parallel in the column direction Y and across the stack of plate lines 100 to define a row of cross points distributed along the row direction X. As further shown, a respective pillar structure 11, 12, 13, 14 may be arranged to extend through the stack of plate lines 100 at each cross point, to define a respective storage capacitor stack 114, 124, 134, 144 at each cross point. While the stack of plate lines 100 is shared by (i.e. common to) the row of storage capacitor stacks 114, 124, 134, 144, each cross point and each storage capacitor stack 114, 124, 134, 144 of the row may be associated with a respective bit line select transistor BST1, BST2, BST3, BST4. The respective first current terminals (e.g. drains) of the bit line select transistor BST1, BST2, BST3, BST4 may be coupled to the bit line BL1, BL2, BL3, BL4 associated with the respective cross point. The respective second current terminals (e.g. sources) of the bit line select transistor BST1, BST2, BST3, BST4 may be coupled to the metal pillar of the associated pillar structure 11, 12, 13, 14. The respective gate terminals of the bit line select transistor BST1, BST2, BST3, BST4 may be formed by a respective individual gate metal layer GL1, GL2, GL3, GL4, each coupled to a respective bit select line WBS1, WBS2, WBS3, WBS4. The bit line select transistors BST1, BST2, BST3, BST4 are thus configured to enable selective access to the associated storage capacitor stack 114, 124, 134, 144.

The sense circuit may be coupled to the metal pillar of each pillar structure 11, 12, 13, 14. For example, the sense circuit may comprise a respective sense transistor ST1, ST2, ST3, ST4 coupled to each respective metal pillar.

The description of the pillar structure 11 and the storage capacitor stack 114 otherwise applies correspondingly to each one of the pillar structures 12, 13, 14 and associated storage capacitor stacks 124, 134, 144.

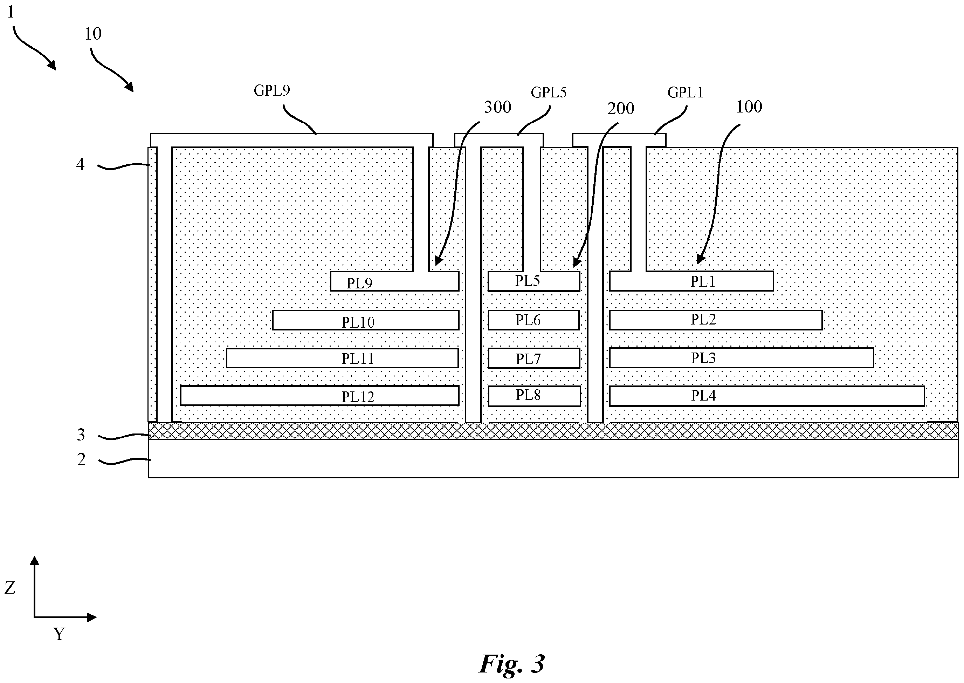

As further shown in Fig. 3-4, the memory device 1 and memory array 10 may comprise a number of stacks of corresponding plate lines 100, 200, 300, extending in parallel in the row direction X and spaced apart in the column direction Y. The set of bit lines BL1 through BL4 may extend over and across each of the stacks of plate lines 100, 200, 300 to define a number row of storage capacitor stacks along each stack of plate lines, each being defined at a respective cross point defined by the set of bit lines BL1 through BL4 and the stacks of plate lines 100, 200, 300. The stacks of plate lines 100, 200, 300 may be separated by an isolation region extending in the row direction X and filled with the insulating material of the insulating layer 4. As shown in Fig. 4, storage capacitor stacks arranged along a same column may share bit line and gate metal layer GL1, GL2, GL3, GL4. The respective stacks of plate lines 100, 200, 300 and associated rows of storage capacitor stacks may otherwise be accessed independently from one another. Thus, the description of the row of storage capacitor stacks 114, 124, 134, 144 along the stack of plate lines 100 applies correspondingly to each one of the further rows of storage capacitor stacks defined along the respective stacks of plate lines 200, 300.

It is to be noted that number of plate lines of each stack of plate lines 100, 200, 300 shown in Fig. 1-4 merely is an example and that each stack of plate lines 100, 200, 300 typically may comprise a considerably larger number of plate lines. The storage capacitor stacks may comprise a corresponding number of storage capacitors. It is further to be noted that the number of bit lines and storage capacitor stacks along each row of the memory array 10 depicted in Fig. 1-4 merely is an example and that the memory array 10 typically may comprise a considerably larger number of bit lines and storage capacitor stacks along each row. Correspondingly, the memory array 10 may comprise fewer or more stacks of plate lines, and hence rows of storage capacitor stacks, than depicted in Fig. 1-4.

Reference will in the following be made mainly to the row of storage capacitor stacks defined along the stack of plate lines 100. However, the description applies correspondingly to any further row of storage capacitor stacks of the memory array 10.

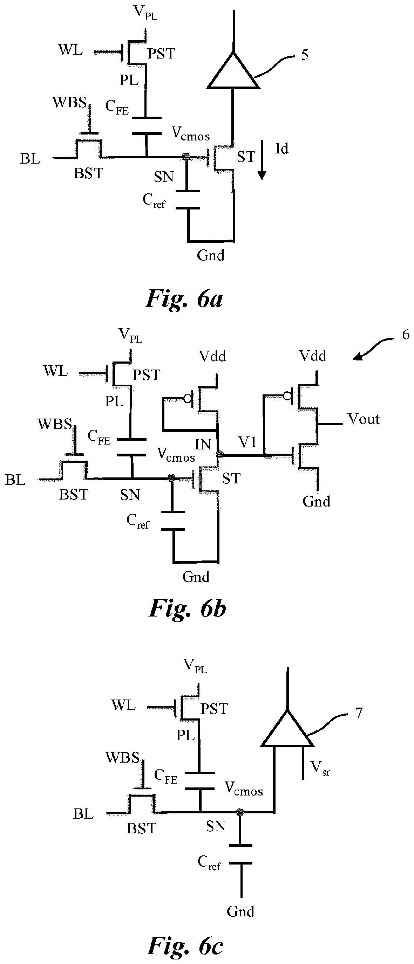

Fig. 6a shows a first implementation of a part of a sense circuit coupled to one of the stacks of storage capacitors, e.g. 114, 124, 134, or 144. For simplicity, Fig. 6 only shows a single one of the storage capacitors of the stack, denoted $C_{FE}$.

The first electrode of the storage capacitor $C_{FE}$ (defined by the plate line PL) is coupled to the second current terminal of the plate line select transistor PST. The second electrode of the storage capacitor $C_{FE}$ (defined by the associated metal pillar) is coupled to a reference voltage node which in the depicted example corresponds to a ground node GND, via a reference capacitor $C_{ref}$ of the sense circuit. The reference capacitor $C_{ref}$ may be formed directly underneath the associated storage capacitor stack, e.g. using the metal pillar as one the capacitor electrodes and a separate metal layer underneath the stack of plate lines as the other capacitor electrode coupled to the reference voltage node. The reference capacitor $C_{ref}$ may also be formed separately from the metal pillar and comprised in the CMOS periphery 3.

In any case, the metal pillar and the reference capacitor $C_{ref}$ may be coupled (i.e. by an Ohmic connection) to a common circuit node SN defining a sense node of the sense circuit. The reference capacitor $C_{ref}$ together with the storage capacitor $C_{FE}$ defines a capacitive divider, wherein the capacitance of the storage capacitor may be $C_{high}$ if the storage capacitor is set to the first polarization state and $C_{low}$ if the storage capacitor is set to the second polarization state. Hence, responsive to applying a read voltage to the plate line PL coupled to the storage capacitor $C_{ref}$, the read voltage will be divided between the storage capacitor $C_{FE}$ and the reference capacitor $C_{ref}$. Hence, a voltage $V_{CMOS}$ of the sense node SN responsive to the read voltage will depend on the polarization state of the storage capacitor $C_{FE}$.

Further with reference to Fig. 6a, the sense circuit comprises a sense transistor ST having a gate coupled to the sense node SN, a first current terminal coupled to the reference voltage node GND and a second current terminal coupled to a sense amplifier 5 of the memory device 1. The sense amplifier 5 may be comprised in the CMOS periphery 3. The sense amplifier 5 is configured to sense the voltage at the sense node SN by sensing a drain current Id through the sense transistor ST responsive to the read voltage. A small change in voltage at the sense node SN results in a corresponding change in gate voltage of the sense transistor ST, which in turn may be translated to a variation in the drain current Id.

By proper tuning of the capacitance of the reference capacitor $C_{ref}$ relative the read voltage, the first and second capacitance values $C_{high}$ and $C_{low}$ of the storage capacitor $C_{FE}$ and a threshold voltage of the sense transistor ST, the voltage at the sense node SN may be varied between exceeding the threshold voltage and being less than the threshold voltage, in dependence on the polarization state of the storage capacitor $C_{FE}$. If the storage capacitor $C_{FE}$ is in the first polarization state the drain current Id may hence correspond to a subthreshold or off-state current. Conversely, if storage capacitor $C_{FE}$ is in the second polarization state the drain current Id may correspond to an on-state current, which typically may be considerable greater than the subthreshold or off-state current. Hence, a small change in capacitance of the storage capacitor $C_{FE}$ may be translated to a large variation in the drain current Id, which may be sensed by the sense amplifier 5 and used to determine the polarization state of the storage capacitor $C_{FE}$.

Fig. 6b shows a second implementation of the sense circuit. The second implementation corresponds to the first implementation but comprises, instead of amplifier 5, an amplifier circuit 6 configured to digitize the output of the sense transistor ST to either a logic low level (GND) and a logic high level (VDD). The amplifier circuit 6 comprises a pull-up transistor having a drain coupled to a supply voltage node (VDD) and a source coupled to a gate terminal of the pull-up transistor and the drain of the sense transistor ST via an internal node IN of the amplifier circuit 6. The internal node IN is coupled to an input of a CMOS inverter pair which generates the digitized output of the sense circuit 6. When the capacitance of the storage capacitor $C_{FE}$ is $C_{low}$, the sense node voltage $V_{CMOS}$ of the sense node SN will be lower than the threshold voltage of the sense transistor ST, wherein the sense transistor ST is switched off. The voltage V1 at the internal node IN will then be pulled high (VDD) by the pull-up transistor, which will be converted to a low logic level output by the inverter. Conversely, when the capacitance of the storage capacitor $C_{FE}$ is $C_{high}$, the sense node voltage $V_{CMOS}$ of the sense node SN will exceed the threshold voltage of the sense transistor ST, wherein the sense transistor ST is switched on. The pull-up transistor will then be switched off and the voltage V1 at the internal node IN will be converted to a low logic level output by the inverter.

Fig. 6c shows a third implementation of the sense circuit. The second implementation corresponds to the first implementation but differs in that the sense transistor ST is replaced by a direct connection between the sense node SN to a differential amplifier 7. The differential amplifier 7 is configured to compare the voltage $V_{CMOS}$ at the sense node SN to a reference sense voltage $V_{sr}$ and provide an output signal amplifying the difference.

The reference sense voltage $V_{sr}$ may for example be set to a level intermediate a first sense node voltage $V_{CMOS,1}$ and a second sense node voltage $V_{CMOS,2}$, wherein the first sense node voltage $V_{CMOS,1}$ is the voltage at the sense node SN in response to the read voltage when the storage capacitor $C_{FE}$ has the first polarization state, and wherein the second sense node voltage $V_{CMOS,2}$ is the voltage at the sense node SN in response to the read voltage when the storage capacitor $C_{FE}$ has the second polarization state, i.e. $V_{sr} \approx (V_{CMOS,1} + V_{CMOS,2}) / 2$. The different polarization states may thus be translated to a high logic level (VDD) responsive to the sense node voltage $V_{CMOS}$ exceeding the reference sense voltage $V_{sr}$, and a low logic level (VSS or GND) responsive to the sense node voltage $V_{cmos}$ being lower than the reference sense voltage $V_{sr}$.

A design parameter of the sense circuits as shown above is the capacitance ratio CR, which may be defined as:

$$CR = \frac{(C_{ref} + C_p + C_{MOS})}{C_{FE}}$$

where $C_{MOS}$ is the gate capacitance of the sense transistor ST and $C_p$ is the parasitic capacitance. This allows the sense node voltage VCMOS to be calculated as:

$$V_{cmos} = \frac{1}{1 + CR} \times V_{read}$$

where $V_{read}$ is the applied read voltage.

As a non-limiting illustrative example, given a read voltage $V_{read}$ of 1.5 V, to obtain a 200 mV difference at the sense node for the $C_{high}$ and $C_{low}$ states of the storage capacitor $C_{FE}$, the storage capacitor should be designed such that $C_{high} / C_{low} \approx 4$.

Accordingly, using either of the above implementations of the sense circuit, the memory device 1 may implement a non-destructive read operation for determining a polarization state of a storage capacitor stack, such as any one of the stacks 114, 124, 134, 144 along the stack of plate lines 100. The read operation may be performed by a memory controller implemented in the CMOS periphery 3 of the memory device 1. The read operation may comprise:

- disabling each bit line select transistor BST1 through BST4;
- enabling the plate line select transistor coupled to the plate line associated with the selected storage capacitor (e.g. PST1 coupled to PL1 associated with the storage capacitor 1141);
- applying, via the enabled plate line select transistor (e.g. PST1), a read voltage $V_{read}$ to the plate line (e.g. PL1) associated with the selected storage capacitor (e.g. 1141), wherein the read voltage $V_{read}$ is distributed across the selected storage capacitor (e.g. 1141) and the reference capacitor $C_{ref}$ of the sense circuit (of either Fig. 6a or 6b); and
- determining the polarization state of the selected storage capacitor (eg. 1141) by sensing, using the sense circuit (of either Fig. 6a or 6b), the voltage $V_{CMOS}$ at the sense node SN responsive to the read voltage $V_{read}$.

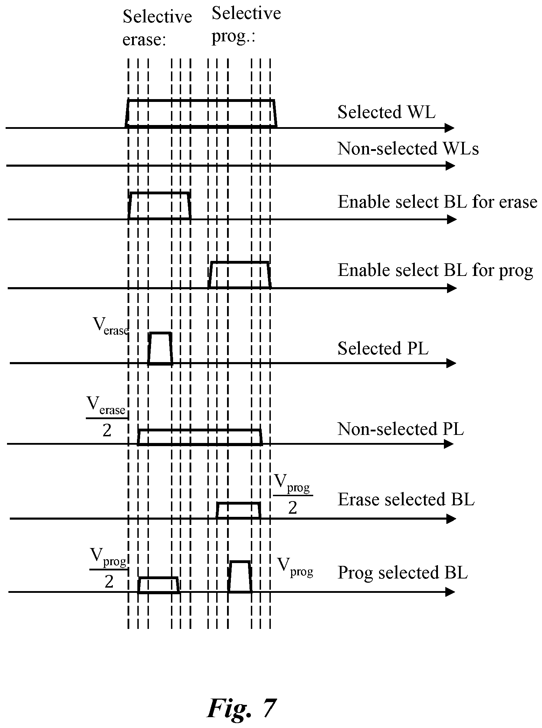

Fig. 7 shows a first write scheme suitable for the memory device 1. The first write scheme may be performed by a write circuitry implemented in the CMOS periphery 3. The first write scheme as shown in Fig. 7 comprises two sequential steps, an erase step and a program step. While in Fig. 7, the erase step is performed prior to the program step, the opposite order is also possible. To facilitate understanding, reference will by way of example further be made to the Fig. 5.

In the erase step, the write circuitry erases only selected storage capacitors along the selected plate line. The erase step comprises as shown:

- Selectively enable only one plate line select transistors (e.g. enable PST1 by applying an on-voltage to WL1).
- Selectively enable only selected bit line transistors coupled to storage capacitors which are to be erased (e.g. enable BST1 by applying an on-voltage to WBS1).
- Apply an erase voltage Verase to the selected plate line (e.g. apply Verase to the PL1 via the enabled PST1 and global plate line GPL1).
- Optionally, apply Verase /2 to non-selected plate lines to reduce a risk of causing write disturb in non-selected storage capacitors (e.g. apply Verase/2 to the global plate lines GPL2, GPL3 and GPL4 coupled to the non-enabled plate line select transistors PST2, PST3, PST4).
- Apply a reference voltage (e.g. ~0 V) to the bit lines associated with the storage capacitors to be erased (e.g. BL1).
- Optionally, apply a fractional program voltage (e.g. Vprog/2) to the bit lines associated with storage capacitors which are to be programmed to reduce a risk of disturbing storage capacitors along the selected plate line which are to be programmed or not to be erased (e.g. BL2 BL3, BL4).

In the program step, the write circuitry programs only selected storage capacitors along the selected plate line. The program step comprises:

- Selectively enable only one plate line select transistors (as shown typically the same plate line select transistor as in the erase step, such as PST1).
- Selectively enable only selected bit line transistors coupled to storage capacitors which are to be programmed (e.g. enable BST2 by applying an on-voltage to WBS2).
- Apply the reference voltage (e.g. ~0 V) to the selected plate line PL (e.g. apply the reference voltage to the PL1 via the enabled PST1 and global plate line GPL1).
- Optionally, apply a fractional erase voltage (e.g. Verase/2) to non-selected plate lines to reduce a risk of causing write disturb in non-selected storage capacitors (e.g. apply Verase/2 to the global plate lines GPL2, GPL3 and GPL4 coupled to the nonenabled plate line select transistors PST2, PST3, PST4).
- Optionally, apply a fractional program voltage (e.g. Vprog/2) to the bit lines associated with storage capacitors which should remain erased (i.e. the storage capacitors that were erased in the erase step) (e.g. BL1).

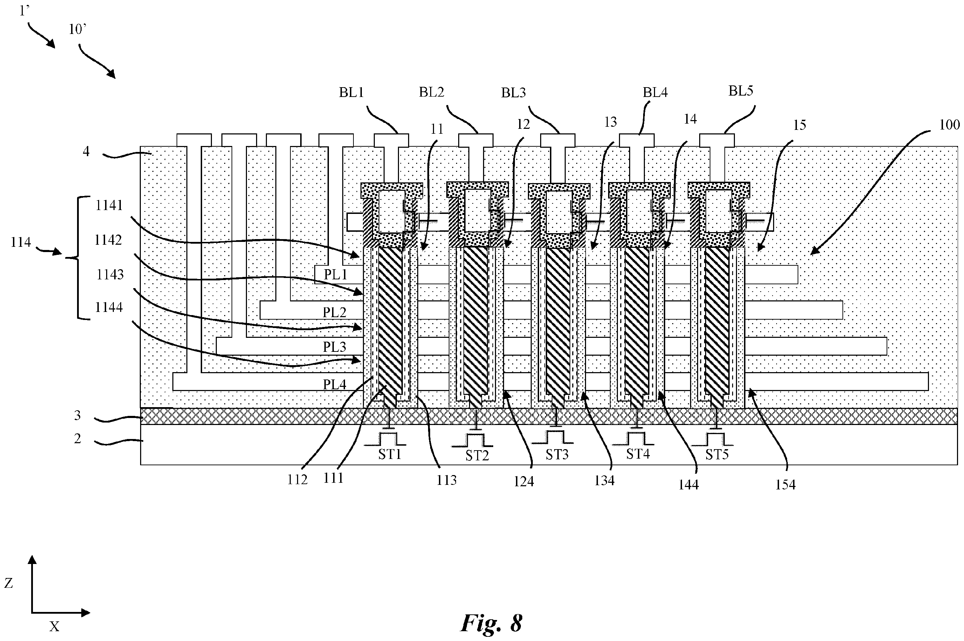

Fig. 8 and 9 schematically shows a cross sectional view and a top-down view, respectively, of a memory device 1' according to a further embodiment. The memory device 1 corresponds to the memory device 1 discussed above, however differs in that the gate terminals of bit line select transistors BST1 through BST5 provided along each row and stack of plate lines 100 of the array 10' are coupled of a same bit select line WBS. In case of more than one stack of plate lines, the same bit select line WBS may even be shared by all bit select transistors of the memory array 10', as shown in Fig. 9. Thus, the gate terminals of the bit line select transistors BST1 through BST5 may be formed in a same gate metal layer GL overlying each of sets of stacks of plate lines 100, 200, 300. This enables reduced footprint of the memory array 1' since isolation regions between the gate terminals may be obviated.

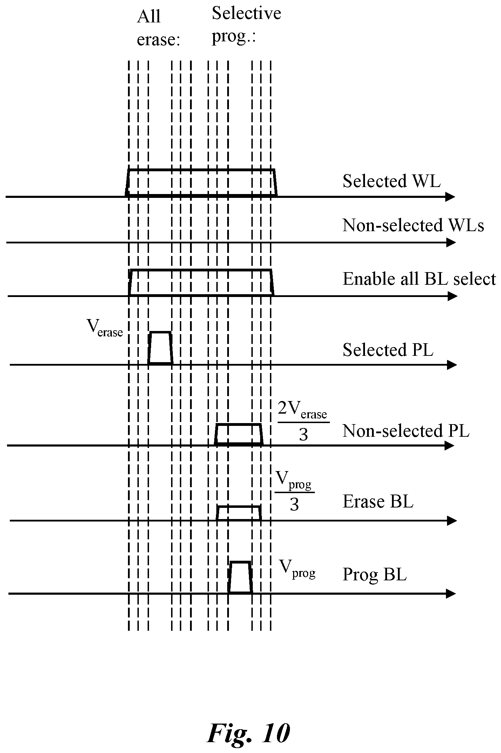

Fig. 10 shows a second write scheme suitable for the memory device 1' with the shared bit select line WLS. The first write scheme may be performed by a write circuitry implemented in the CMOS periphery 3. The first write scheme as shown in Fig. 7 comprises two steps, an erase step followed by a program step. The erase step erases all storage capacitors along the plate line. The program step then selectively programs selected storage capacitors along the plate line. To facilitate understanding, reference will by way of example further be made to the Fig. 5
The erase step comprises as shown:

- Enable only one plate line, and all bit line select transistors (e.g. enable PST1 by applying an on-voltage to WL1 and BST1 through BST4 by applying an on-voltage to the common WBS).
- Apply an erase voltage Verase to the selected plate line (e.g. apply Verase to the PL1 via the enabled PST1 and global plate line GPL1).
- Optionally, apply a reference voltage (e.g. ~0 V) to all non-selected plate lines (e.g. apply the reference voltage to the global plate lines GPL2, GPL3 and GPL4 coupled to the non-enabled plate line select transistors PST2, PST3, PST4).
- Apply the reference voltage (e.g. ~0 V) to all bit lines (e.g. BL1 through BL4).

The program step comprises as shown:

- Enable only one plate line, and all bit line select transistors (as shown typically the same plate line select transistor as in the erase step, such as PST1).
- Apply the reference voltage (e.g. ~0 V) to the selected plate line (e.g. apply the reference voltage to the PL1 via the enabled PST1 and global plate line GPL1).
- Apply a fractional erase voltage (e.g. 2*Verase/3) to the non-selected plate lines (e.g. apply the fractional erase voltage to the global plate lines GPL2, GPL3 and GPL4 coupled to the non-enabled plate line select transistors PST2, PST3, PST4).
- Apply a fractional program voltage (e.g. Vprog/3) to the bit lines associated with the storage capacitors which should remain erased (e.g. apply the fractional program voltage to BL1 and BL2).
- Apply the program voltage Vprog to the bit lines of the storage capacitors that are to be programmed (e.g. apply the Vprog to BL3 and BL4).

The person skilled in the art realizes that the present invention by no means is limited to the embodiments described above. On the contrary, many modifications and variations are possible within the scope of the appended claims. For example, while in the above illustrated examples, the bit line select transistors are provided in the back-end-of-line, arranged on top of the respective pillar structures, it is also possible to implement the bit line select transistors in the CMOS periphery and connect each bit line select transistor to the metal core of its respective pillar structure by a combination of vertical and horizontal interconnects in the interconnect structure.

**Claims**

1. A ferroelectric memory device (1) comprising:
a memory array (10) arranged in a back-end-of-line interconnect structure of the memory device, the memory array comprising:

> a vertical stack of horizontally extending plate lines (100); and
> a pillar structure (11) extending vertically through the stack of plate lines (100) and comprising a metal core (111) and a storage layer stack comprising an oxide semiconductor layer (112) circumferentially surrounding the metal core (111) and a ferroelectric layer (113) circumferentially surrounding the oxide semiconductor layer (112),
> wherein a vertical stack of ferroelectric storage capacitors (114) is defined along the pillar structure (11), each ferroelectric storage capacitor (1141-1144) comprising a first capacitor electrode formed by a plate line (PL1-PL4) of the stack of plate lines (100), a second capacitor electrode formed by the metal core (111) of the pillar structure (11), and a storage region formed by a portion of the storage layer stack sandwiched between the respective first capacitor electrode (PL1-PL4) and the metal core (111);
> the memory device (1) further comprising:

>> a bit line select transistor (BST1) comprising a first current terminal coupled to a bit line (BL1) of the memory array (10), a second current terminal coupled to the metal core (111) of the pillar structure (11), and a gate terminal coupled to a bit select line (WBS1);
>> a plate line select transistor (PST1-PST4) coupled to a respective one of the plate lines (PL1-PL4); and
>> a sense circuit (5, 6, 7) coupled to the metal core (111) of the pillar structure (11).

2. The memory device according to claim 1, wherein the bit line select transistor (BST1) is arranged on top of the pillar structure (11) and comprises a channel layer of an oxide semiconductor material.

3. The memory device according to any one of the preceding claims, wherein the metal core (111) of the pillar structure (11) is coupled to a reference voltage node (GND) via a reference capacitor ($C_{ref}$) arranged below the vertical stack of ferroelectric storage capacitors (114), and wherein the sense circuit (5, 6, 7) is coupled to a sense node (SN) between the metal core (111) and the reference capacitor ($C_{ref}$).

4. The memory device according to claim 3,

> wherein each ferroelectric storage capacitor (1141-1144) is switchable between a first polarization state resulting in a first capacitance of the ferroelectric storage capacitor, and a second polarization state resulting in a second capacitance of the ferroelectric storage capacitor, the second capacitance being smaller than the first capacitance, and
> wherein a ratio of the capacitance at the sense node (SN) and the second capacitance exceeds a ratio of the capacitance at the sense node (SN) and the first capacitance by a factor of 1.3 or more.

5. The memory device according to any one of claims 3-4,
wherein the memory device further comprises a memory controller (3) configured to perform a read operation for determining a polarization state of a selected ferroelectric storage capacitor (1141, $C_{FE}$) among the stack of ferroelectric storage capacitors (114) by:

> disabling each bit line select transistor (BST1);
> enabling the plate line select transistor (PST1) coupled to the plate line (PL1) associated with the selected ferroelectric storage capacitor;
> applying, via the enabled plate line select transistor (PST1), a read voltage to the plate line (PL1) associated with the selected ferroelectric storage capacitor, wherein the read voltage is distributed across the selected ferroelectric storage capacitor (1141, $C_{FE}$) and the reference capacitor ($C_{ref}$); and
> determining the polarization state of the selected ferroelectric storage capacitor (1141, $C_{FE}$) by sensing, using the sense circuit (5, 6, 7), the voltage at the sense node (SN) responsive to the read voltage.

6. The memory device according to claim 3-5, wherein the sense circuit comprises a differential amplifier (7) configured to compare the voltage at the sense node (SN) to a reference sense voltage.

7. The memory device according to any one of claims 3-5, wherein the sense circuit comprises a sense transistor (ST) having a gate coupled to the sense node (SN), a first current terminal coupled to the reference voltage node (GND) and a second current terminal coupled to an amplifier (5, 6) of the memory device.

8. The memory device according to claim 7, wherein the effective capacitance at the sense node (SN) is such that, responsive to the read voltage, the sense transistor (ST) is enabled when the selected ferroelectric storage capacitor (1141, $C_{FE}$) is in the first polarization state, and disabled when the selected ferroelectric storage capacitor (1141, $C_{FE}$) is in the second polarization state.

9. The memory device according to any one of the preceding claims, wherein the stack of plate lines (100) extend in a row direction (X) of the memory array (10) and the memory array further comprises a set of bit lines (BL1-BL4), wherein the bit lines extend over and across the stack of plate lines (100) in a column direction (Y) of the memory array to define a row of cross points between the set of bit lines (BL1-BL4) and the stack of plate lines (100), the memory array comprising:

a pillar structure (11, 12, 13, 14) at each cross point, each pillar structure extending vertically through the stack of plate lines (100) and comprising a metal core and a storage layer stack comprising a ferroelectric layer and an oxide semiconductor layer circumferentially surrounding the metal core,
wherein a vertical stack of ferroelectric storage capacitors (114, 124, 134, 144) is defined along the respective pillar structure (11, 12, 13, 14) at each cross point, each ferroelectric storage capacitor of each stack of ferroelectric storage capacitors comprising a first capacitor electrode formed by a plate line (PL1-PL4) of the stack of plate lines (100), a second capacitor electrode formed by the metal core of the respective pillar structure (11, 12, 13, 14), and a storage region formed by a portion of the storage layer stack of the respective pillar structure (11, 12, 13, 14) sandwiched between the respective first capacitor electrode and the respective metal core;
wherein the memory device comprises a respective bit line select transistor (BST1-BST4) associated with each respective cross point, each comprising a first current terminal coupled to the bit line at the respective cross point, a second current terminal coupled to the metal core of the pillar structure (11, 12, 13, 14) at the respective cross point, and a gate terminal coupled to a bit select line (WBS1-WBW4, WBS);
wherein the sense circuit (5, 6, 7) is connected to the metal core of each pillar structure (11, 12, 13, 14).

10. The memory device according to claim 9, wherein each bit line select transistor (BST1-BST4) is arranged on top of the pillar structure (11, 12, 13, 14) at the associated cross point and comprises a channel layer of an oxide semiconductor material.

11. The memory device (1, 1') according to any one of claims 9-10, wherein the gate terminal of each bit line select transistor (BST1-BST4) is coupled to a respective bit select line (WBS1-WBS4) or wherein the gate terminals of the bit line select transistors (BST1-BST4) are coupled to a same bit select line (WBS).

12. The memory device (1) according to claim 11, wherein the gate terminal of each bit line select transistor (BST1-BST4) is coupled to a respective bit select line (WBS1-WBS4) and the memory device (1) further comprises write circuitry (3) configured to:

selectively enable one of the plate line select transistors (PST1), the enabled plate line select transistor being coupled to a plate line (PL1) associated with a first set of ferroelectric storage capacitors to be erased and a second set of ferroelectric storage capacitors to be programmed,
and while the selected plate line select transistor (PST1) is enabled:

perform an erase step comprising: selectively enabling the bit line select transistors (BST1) coupled to the first set of ferroelectric storage capacitor, and simultaneously applying an erase voltage to said plate line (PL1) and a reference voltage to the bit lines (BL1) coupled to the enabled bit line select transistors (BST1); and
perform a program step comprising: selectively enabling the bit line select transistors (BST2) coupled to the second set of ferroelectric storage capacitor, and simultaneously applying a program voltage to the bit lines (BL2) coupled to the enabled bit line select transistors (BST2) and the reference voltage to said plate line (PL1).

13. The memory device (1') according to claim 11, wherein the gate terminals of the bit line select transistors (BST1-BST4) are coupled to a same bit select line (WBS) and the memory device (1') further comprises write circuitry (3) configured to:

selectively enable one of the plate line select transistors (PST1) and each bit line select transistor (BST1-BST4), the enabled plate line select transistor being coupled to a plate line (PL1) associated with a first set of ferroelectric storage capacitors to be erased and a second set of ferroelectric storage capacitors to be programmed,

and while the selected plate line select transistor and each bit line select transistor are enabled:

perform an erase step comprising: simultaneously applying an erase voltage to said plate line (PL1) and a reference voltage to each bit line (BL1-BL4); and

perform a program step comprising: simultaneously applying a program voltage to the bit lines (BL3, BL4) coupled to the second set of ferroelectric storage capacitors and a fractional program voltage to the bit lines (BL1, BL2) coupled to first set of ferroelectric storage capacitors, and the reference voltage to said plate line (PL1).

14. The memory device according to any one of the preceding claims, wherein the plate line select transistor or transistors and the sense circuit is comprised in a peripheral complementary metal oxide semiconductor, CMOS, circuit (3) of the memory device.

15. The memory device according to any one of the preceding claims, wherein the oxide semiconductor layer (112) of the pillar structure (11) and/or the channel layer of each bit line select transistor (BST1) is a high mobility oxide semiconductor material, such as indium gallium zinc oxide, ZnO, WO, InWO, InSnO, GaZnO, MgZnO, MgAlZnO or MoO.

*Fig. 1*

**Fig. 2**

EP 4 576 092 A1

*Fig. 3*

EP 4 576 092 A1

*Fig. 4*

EP 4 576 092 A1

*Fig. 5*

**Fig. 6a**

**Fig. 6b**

**Fig. 6c**

*Fig. 7*

*Fig. 8*

**Fig. 9**

EP 4 576 092 A1

All
erase:

Selective
prog.:

Selected WL

Non-selected WLs

Enable all BL select

$V_{erase}$

Selected PL

$\frac{2V_{erase}}{3}$ Non-selected PL

$\frac{V_{prog}}{3}$ Erase BL

$V_{prog}$ Prog BL

*Fig. 10*

Europäisches
Patentamt

European
Patent Office

Office européen
des brevets

**EUROPEAN SEARCH REPORT**

Application Number

EP 23 22 0118

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2023/101111 A1 (SHIVARAMAN SHRIRAM [US] ET AL) 30 March 2023 (2023-03-30) | 1-11,14, 15 | INV. G11C11/22 |
| A | * paragraph [0018] - paragraph [0040]; figures 1A-2,1B * | 12,13 | H10B53/20 H10B53/30 |
| | ----- | | |
| Y | US 2022/157833 A1 (KOBAYASHI MASAHARU [JP] ET AL) 19 May 2022 (2022-05-19) * paragraph [0067] - paragraph [0068]; figures 7,8,21,22 * | 1-11,14, 15 | |
| | ----- | | |
| Y | MUKHERJEE S ET AL: "Pulse-Based Capacitive Memory Window with High Non-Destructive Read Endurance in Fully BEOL Compatible Ferroelectric Capacitors", 2023 INTERNATIONAL ELECTRON DEVICES MEETING (IEDM), IEEE, 9 December 2023 (2023-12-09), pages 1-4, XP034539324, DOI: 10.1109/IEDM45741.2023.10413879 [retrieved on 2024-02-07] * page 1, right-hand column, paragraph 2 - page 3, right-hand column, last paragraph; figure 3 * | 1-11,14, 15 | |
| | ----- | | TECHNICAL FIELDS SEARCHED (IPC) G11C H10B H01L |
| Y | US 2019/147932 A1 (KAWAMURA CHRISTOPHER [US] ET AL) 16 May 2019 (2019-05-16) * paragraph [0051] - paragraph [0057]; figures 4A, 4B * | 3-8 | |
| | ----- | | |
| | -/-- | | |

The present search report has been drawn up for all claims

| Place of search | Date of completion of the search | Examiner |
|---|---|---|
| The Hague | 27 May 2024 | Colling, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
........................................................................
& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

Application Number

EP 23 22 0118

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SCHENK TONY ET AL: "A New Generation of Memory Devices Enabled by Ferroelectric Hafnia and Zirconia", 2021 IEEE INTERNATIONAL SYMPOSIUM ON APPLICATIONS OF FERROELECTRICS (ISAF), IEEE, 16 May 2021 (2021-05-16), pages 1-11, XP033940218, DOI: 10.1109/ISAF51943.2021.9477377 [retrieved on 2021-07-07] * the whole document * | 1-15 | |

-----

|  | TECHNICAL FIELDS SEARCHED (IPC) |
|---|---|

The present search report has been drawn up for all claims

| Place of search | Date of completion of the search | Examiner |
|---|---|---|
| The Hague | 27 May 2024 | Colling, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................................

& : member of the same patent family, corresponding document

EPO FORM 1503 03.82 (P04C01)

page 2 of 2

**ANNEX TO THE EUROPEAN SEARCH REPORT
ON EUROPEAN PATENT APPLICATION NO.**

EP 23 22 0118

This annex lists the patent family members relating to the patent documents cited in the above-mentioned European search report.
The members are as contained in the European Patent Office EDP file on
The European Patent Office is in no way liable for these particulars which are merely given for the purpose of information.

27-05-2024

| Patent document cited in search report | Publication date | Patent family member(s) | Publication date |
|---|---|---|---|
| US 2023101111 A1 | 30-03-2023 | NONE | |
| US 2022157833 A1 | 19-05-2022 | JP 7360203 B2 | 13-10-2023 |
| | | JP WO2021024598 A1 | 11-02-2021 |
| | | KR 20220034890 A | 18-03-2022 |
| | | TW 202107464 A | 16-02-2021 |
| | | US 2022157833 A1 | 19-05-2022 |
| | | WO 2021024598 A1 | 11-02-2021 |
| US 2019147932 A1 | 16-05-2019 | US 9786348 B1 | 10-10-2017 |
| | | US 2018005680 A1 | 04-01-2018 |
| | | US 2018158501 A1 | 07-06-2018 |
| | | US 2019147932 A1 | 16-05-2019 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **LUO et al.** Non-volatile, small-signal capacitance in ferroelectric capacitors. *Appl. Phys. Lett.*, 2020, vol. 117, 073501

- **TRIPATHI et al.** Investigation of BiFeO3/HfO2 gate stack for ferroelectric field effect transistors in IOT applications. *Journal of Materials Science: Materials in Electronics*, 2021, vol. 32, 22517-22526